# EUROPÄISCHE PATENTSCHRIFT

(11) **EP 3 246 430 B1**
(45) Veröffentlichungstag und Bekanntmachung des Hinweises auf die Patenterteilung: **08.12.2021**
(21) Anmeldenummer: 16170521.5
(22) Anmeldetag: 20.05.2016
(51) Int. Cl.: C23C 28/00, C23C 14/02, C23C 14/58, C23C 14/06, F01D 5/28

(54) **VERFAHREN ZUR HERSTELLUNG VON SCHAUFELN ODER SCHAUFELANORDNUNGEN EINER STRÖMUNGSMASCHINE MIT EROSIONSCHUTZSCHICHTEN UND ENTSPRECHEND HERGESTELLTES BAUTEIL**
METHOD FOR THE PREPARATION OF BLADES OR BLADE ASSEMBLIES OF A FLOW ENGINE WITH EROSION PROTECTION LAYERS AND CORRESPONDINGLY MANUFACTURED COMPONENT
PROCÉDÉ DE FABRICATION D'AUBES OU DE SYSTÈME D'AUBES D'UNE TURBOMACHINE COMPRENANT DES COUCHES DE PROTECTION CONTRE L'ÉROSION ET COMPOSANT AINSI FABRIQUÉ

(43) Veröffentlichungstag der Anmeldung: 22.11.2017
(73) Patentinhaber: MTU Aero Engines AG, 80995 München (DE)
(72) Erfinder: Windprechtinger, Jörg, 81373 München (DE); Stolle, Ralf, 82515 Wolfratshausen (DE); Utz, Philipp, 85757 Karlsfeld (DE); Uihlein, Thomas, 85221 Dachau (DE); Gether, Markus, 85276 Hettenshausen (DE)

(56) Entgegenhaltungen:
- EP-A1- 1 741 876
- EP-A1- 2 468 916
- EP-A2- 2 172 577
- WO-A1-2005/066384
- DE-A1-102004 017 646
- DE-A1-102007 050 918
- DE-A1-102008 019 891
- DE-T5-112009 002 430
- US-B1- 6 434 876

## Beschreibung

### HINTERGRUND DER ERFINDUNG

### GEBIET DER ERFINDUNG

Die vorliegende Erfindung betrifft ein Verfahren zur Herstellung einer Schaufel oder Schaufelanordnung für eine Strömungsmaschine sowie eine Schaufel, insbesondere eine Blisk, für eine Strömungsmaschine, die mit dem Verfahren hergestellt worden ist.

### STAND DER TECHNIK

Strömungsmaschinen, wie stationäre Gasturbinen oder Flugtriebwerke, weisen unter anderem eine Vielzahl von Schaufeln auf, die an einem Rotor drehbar angeordnet sind, um entweder das Fluid, welches durch die Strömungsmaschine fließt, zu verdichten oder durch das Fluid zur Drehung angetrieben zu werden.

Um die Strömungsverluste zwischen den sich drehenden Schaufeln und einer umgebenden Strömungskanalbegrenzung zu minimieren, muss der Spalt zwischen den Schaufelspitzen am radialen Ende der Schaufeln und der Strömungskanalbegrenzung möglichst klein sein, sodass möglichst wenig Fluid durch den Spalt zwischen Strömungskanalbegrenzung und Schaufeln fließen kann. Allerdings kann es bei der Ausbildung eines zu geringen Spalts zum Kontakt zwischen den Schaufelspitzen und einer umgebenden Strömungskanalbegrenzung kommen, sodass es z.B. bei Verwendung von Titan - Werkstoffen für die Schaufeln und die Strömungskanalbegrenzung zur Entstehung von so genanntem Titan - Feuer mit entsprechender Beschädigung der Schaufeln kommen kann.

Zur Vermeidung von Strömungsverlusten werden bei bekannten Strömungsmaschinen zur Abdichtung zwischen den Schaufelspitzen und der Strömungskanalbegrenzung sogenannte Labyrinthdichtungen vorgesehen, bei welchen die Schaufelspitzen sich in einer Nut bewegen, die sich beim Betrieb der Strömungsmaschine in einem Dichtungsmaterial an der Strömungskanalbegrenzung durch entsprechendes Einschleifen der Schaufelspitzen ausbildet. Entsprechend ist es auch bekannt an den Schaufelspitzen so genannte Schaufelspitzenpanzerungen vorzusehen, die z.B. in einer Metall - Matrix eingelagerte Hartstoffpartikel aufweisen, um mittels der Hartstoffpartikel die Nut für die Labyrinthdichtung im gegenüberliegenden Dichtungsmaterial der Strömungskanalbegrenzung einzuschneiden und die Schaufelspitze vor Verschleiß zu schützen.

Darüber hinaus umfassen Schaufeln von Strömungsmaschinen zusätzlich am Schaufelblatt Schutzbeschichtungen, wie Erosionsschutzschichten, um das Schaufelmaterial im Bereich des Schaufelblatts ebenfalls vor Verschleiß, beispielsweise durch Erosion, zu schützen.

Aus den deutschen Offenlegungsschriften DE 10 2007 027 335 A1, DE 10 2007 050 918 A1 und DE 10 2008 019 891 A1 sowie der internationalen PCT-Anmeldung WO 2005/066 384 A1 sind verschiedene Verschleißschutzbeschichtungen bzw. Erosionsschutzschichten für Bauteile von Strömungsmaschinen bekannt. Die Veröffentlichung der europäischen Patentanmeldung EP 1 741 876 A1 offenbart eine Schaufel einer Turbomaschine mit einer Schaufelspitzenpanzerung und einer Verschleißschutzschicht, während die Veröffentlichung der europäischen Patentanmeldung EP 2 172 577 A2 eine Schutzschicht gegen sand fouling und micropitting offenbart.

Auf Grund der unterschiedlichen Belastungen von Schaufelspitzen, Schaufelblättern oder allgemein unterschiedlichen Regionen einer Schaufel ist es erforderlich, an einer Schaufel für eine Strömungsmaschine unterschiedliche Beschichtungen anzuordnen, wie beispielsweise eine Spitzenpanzerung an den Schaufelspitzen und eine Erosionsschutzbeschichtung am Schaufelblatt, wobei jedoch sichergestellt werden muss, dass die Beschichtungen ihre gewünschte Funktion möglichst optimal erfüllen können.

Folglich besteht eine Schwierigkeit darin, geeignete Schichten in der richtigen Art und Weise abzuscheiden, um die optimalen Eigenschaften der Beschichtungen zur Geltung zu bringen. Dies gilt für einzelne Schaufeln, die nach Fertigstellung als stationäre Schaufeln in einem Strömungskanal oder als Laufschaufeln an einer Rotorscheibe angeordnet werden können, aber auch im besonderen Maße für beschaufelte Scheiben, so genannte Blisks (blade integrated disk or integrally bladed rotor), bei denen aufgrund der komplexen Struktur eine entsprechende Beschichtung der Schaufeln noch schwieriger durchzuführen ist.

### OFFENBARUNG DER ERFINDUNG

### AUFGABE DER ERFINDUNG

Die vorliegende Erfindung hat somit die Aufgabe, ein Verfahren für die Herstellung einer Schaufel oder Schaufelanordnung einer Strömungsmaschine und insbesondere einer Schaufelanordnung, wie einer Blisk, sowie entsprechend hergestellte Schaufeln bzw. Blisken bereitzustellen, die ein ausgewogenes Eigenschaftsprofil hinsichtlich des Erosionsschutzes der Schaufelblätter und des Schutzes der Schaufelspitzen insbesondere zur Vermeidung des sogenannten Titanfeuers aufweisen. Gleichzeitig soll das Verfahren einfach durchführbar sein und die entsprechend hergestellten Bauteile sollen einen sicheren und langlebigen Betrieb der Strömungsmaschine ermöglichen.

### TECHNISCHE LÖSUNG

Diese Aufgabe wird gelöst mit einem Verfahren mit den Merkmalen des Anspruchs 1 sowie eine Schaufel, insbesondere Blisk, mit den Merkmalen des Anspruchs 14. Vorteilhafte Ausgestaltungen sind Gegenstand der abhängigen Ansprüche.

Die Erfindung schlägt ein Verfahren vor, bei dem zunächst eine Schaufel bzw. Schaufelanordnung für eine Strömungsmaschine, wie beispielsweise eine Blisk, aus mindestens einem Schaufelwerkstoff hergestellt wird.

Die Schaufel oder Schaufelanordnung wird in mindestens einem Bereich der Schaufel durch ein Oberflächenbearbeitungsverfahren bearbeitet, um die Oberfläche auf die nachfolgende Abscheidung einer Erosionsschutzschicht vorzubereiten.

Nach der Oberflächenbearbeitung wird die Oberfläche der Schaufel gereinigt und anschließend wird eine Erosionsschutzschicht aus mindestens zwei unterschiedlich harten Schichten durch physikalische Dampfphasenabscheidung (PVD physical vapour deposition) in dem mindestens einen, durch Oberflächenbearbeitung vorbereitetem Bereich der Schaufeloberfläche abgeschieden.

Nach dem Abscheiden der Erosionsschutzschicht wird die Oberfläche der Erosionsschutzschicht mittels eines Schichtglättungsverfahrens geglättet, um eine glatte Oberfläche einzustellen, die eine Glätte aufweist, die besser ist als eine vorbestimmte Oberflächenrauheit. Die Oberflächengüte wird laut der Erfindung mit einer mittleren Rauheit Rₐ definiert, die den mittleren Abstand eines Messpunktes auf der Oberfläche zur Mittellinie angibt, wobei die Mittelinie entlang der Bezugsstrecke bzw. Messtrecke das Oberflächenprofil so schneidet, dass die Summe der Profilabweichungen bezogen auf die Mittellinie minimal wird. Die mittlere Rauheit Ra ist laut Anspruch 14 kleiner oder gleich 0,5 µm, insbesondere kleiner oder gleich 0,25 µm. Insbesondere soll die Oberflächengüte mit einer mittleren Rauheit Ra kleiner oder gleich 0,25 µm entlang einer Messstrecke an der Schaufel parallel zur Strömungsrichtung des Fluids einer Strömungsmaschine sein. Dadurch kann der Glättungsaufwand quer zur Strömungsrichtung verringert werden und gleichzeitig wird verhindert, dass die Schichtdicke der aufgebrachten Erosionsschutzschicht unnötig durch Glättung verringert wird. Dadurch kann auch die Lebensdauer der Schicht und des beschichteten Bauteils erhöht werden.

Der Schaufelwerkstoff der Schaufel bzw. einer Blisk kann eine Titan - Legierung, eine Nickel - Legierung, ein Stahl sowie ein Verbundwerkstoff, insbesondere ein Keramik - Matrix - Verbundwerkstoff sein, wobei unter Titan - Legierung und Nickel - Legierung Legierungen zu verstehen sind, deren Hauptbestandteil Nickel oder Titan ist. Eine entsprechende Schaufel oder eine Blisk können aus mehreren Werkstoffen gebildet sein, beispielsweise aus unterschiedlichen Werkstoffen für das Schaufelblatt und den Schaufelfuß bzw. die Scheibe.

Das Oberflächenbearbeitungsverfahren, mit welchem mindestens ein Bereich der Schaufel vor dem Abscheiden der Erosionsschutzschicht bearbeitet wird, kann mindestens ein Verfahren aus der Gruppe sein, die Schleifen, Gleitschleifen, Polieren, Elektropolieren, Verfestigungsstrahlen und Kugelstrahlen umfasst. Durch das Schleifen und Polieren kann eine möglichst glatte und für die Haftung der nachfolgenden Beschichtung günstige Oberfläche eingestellt werden, wobei die glatte Ausbildung der Oberfläche des Grundwerkstoffs der Schaufel bzw. der Blisk auch dafür sorgt, dass die Oberfläche der später abgeschiedenen Erosionsschutzschicht eine bestimmte Oberflächengüte hinsichtlich der Rauheit erreicht. Durch Verfestigungsstrahlen und insbesondere Kugelstrahlen der Oberfläche vor der Aufbringung der Beschichtung kann die Ermüdungsfestigkeit der Schaufeln, insbesondere bei Schaufeln aus Titan - Legierungen, verbessert werden.

Nach der Oberflächenbearbeitung der Schaufel wird die Schaufel gereinigt und anschließend wird die Erosionsschutzbeschichtung durch physikalische Dampfphasenabscheidung (PVD physical vapour deposition), insbesondere Sputtern (Kathodenzerstäubung) oder kathodische Lichtbogenabscheidung, aufgebracht. Die Erosionsschutzbeschichtung kann aus einem mehrlagigen Schichtsystem mit einer oder mehreren sich wiederholenden Abfolgen von mehreren Schichten bestehen, wobei die Schichten durch Metallschichten, Metalllegierungsschichten, Keramikschichten, Metall - Keramik - Schichten und gradierte Metall - Keramik - Schichten gebildet sein können. Insbesondere können die Schichten des mehrlagigen Schichtsystems so gewählt werden, dass jede Abfolge von mehreren Schichten mindestens eine harte und mindestens eine weiche Schicht aufweist, wobei die Härte der Schicht sich durch den relativen Bezug zu der oder den anderen Schichten ergibt, also die Eigenschaft hart in dem Sinn verwendet wird, dass diese Schicht härter ist als mindestens eine andere Schicht des mehrlagigen Schichtsystems bzw. der Schichtabfolge, während eine weiche Schicht entsprechend eine gegenüber den anderen Schichten weichere Schicht darstellt.

Insbesondere kann das mehrlagige Schichtsystem so aufgebaut sein, dass alternierend harte und weiche Schichten vorgesehen sind. Beispielsweise kann als weiche Schicht eine Metallschicht und als harte Schicht eine Keramikschicht vorgesehen sein. Darüber hinaus können zusätzliche Zwischenschichten zwischen der weichen Schicht, beispielsweise einer Metallschicht, und einer harten Schicht, beispielsweise einer Keramikschicht, vorgesehen sein, die unterschiedliche Härtegrade aufweisen können, wie beispielsweise eine Metalllegierungsschicht und eine gradierte Metall - Keramik - Schicht, bei der der Metallanteil ausgehend von einer benachbart angeordneten Metallschicht bzw. Metalllegierungsschicht zu einer auf der anderen Seite angeordneten Keramikschicht abnimmt. Vorzugsweise kann eine Abfolge von Schichten, die im mehrlagigen Schichtsystem mehrmals wiederholt vorliegen kann, eine Metallschicht, eine Metalllegierungsschicht, eine vorzugsweise gradierte Metall - Keramik - Schicht und eine Keramikschicht umfassen.

Eine Abfolge von Schichten kann eine Dicke von bis zu 50 µm aufweisen. Jede einzelne Schicht einer Abfolge von Schichten bzw. eines mehrlagigen Schichtsystems kann eine Dicke von 0,2 µm bis 10 µm aufweisen.

Einzelne Schichten des mehrlagigen Schichtsystems bzw. einer Schichtabfolge können selbst wieder nanostrukturiert sein und mehrere, insbesondere wechselseitig sich widerholende Teilschichten aufweisen, von denen jede Teilschicht eine Dicke von 10 nm bis 200 nm aufweisen kann.

Vorzugsweise kann eine harte Schicht, insbesondere die härteste Schicht, in einem mehrlagigen Schichtsystem bzw. einer Schichtabfolge als nanostrukturierte Schicht mit mehreren sich wechselseitig wiederholenden Teilschichten ausgebildet sein.

Die Schichten können auf Chrombasis gebildet sein und entsprechend Schichten aus Chrom, Chromlegierungen, CrAlN - Schichten und CrN - Schichten umfassen, wobei die Chromlegierung eine Cr - Ni - Legierung sein kann. Die Keramikschicht, die in einer Schichtabfolge oder in einem Mehrlagenschichtsystem eine harte Schicht darstellen kann, kann als Teilschichten sich wechselseitig sich wiederholende CrAlN - und CrN - Schichten aufweisen.

Vor dem Abscheiden der Erosionsschutzschicht mit den entsprechenden Schichten oder Teilschichten kann zwischen dem Grundwerkstoff und der Erosionsschutzschicht zusätzlich eine Diffusionssperrschicht und/oder eine Haftvermittlerschicht abgeschieden werden. Derartige Schichten können ebenfalls aus CrAlN gebildet sein.

Zur Glättung der Erosionsschutzschicht kann die Erosionsschutzschicht geschliffen oder poliert werden und insbesondere durch Gleitschleifen und/oder Elektropolieren bearbeitet werden, um die erforderliche Oberflächengüte hinsichtlich der Rauheit zu erreichen.

Vor oder nach dem Glätten der Erosionsschutzschicht durch ein Schichtglättungsverfahren kann die Oberfläche ebenfalls durch Verfestigungsstrahlen, insbesondere Kugelstrahlen bearbeitet werden, um den Randbereich zu verdichten.

Nach der Bearbeitung der Schaufel durch ein Oberflächenbearbeitungsverfahren und vor dem Abscheiden einer Erosionsschutzschicht kann insbesondere bei Blisken ein Ablängen der Schaufeln auf die gewünschte Schaufellänge und/oder die Abscheidung einer Spitzenpanzerung durchgeführt werden, so dass die Erosionsschutzschicht über die Schaufelspitze oder die Schaufelspitzenpanzerung abgeschieden werden kann. Durch das Abscheiden der zusätzlichen Erosionsschutzschicht im Bereich der Schaufelspitze oder der Schaufelspitzenpanzerung erfolgt ein zusätzlicher Schutz der Schaufelspitze oder der Schaufelspitzenpanzerung.

Nach dem Schichtglättungsverfahren bzw. einer Verfestigung durch eine Strahlbearbeitung ist eine Schaufel bzw. eine Blisk fertig hergestellt, wobei bei Bedarf noch weitere zusätzliche Funktionsschichten auf der Erosionsschutzschicht oder dem restlichen Bauteil abgeschieden werden können.

Die Erosionsschutzschicht kann bei teilweiser Aufbringung auf der Schaufel zu den Rändern der Erosionsschutzschicht mit abnehmender Schichtdicke abgeschieden werden, so dass sich ein kontinuierliche Übergang der Erosionsschutzschicht von einem nicht beschichteten Bereich der Schaufel zu einem beschichteten Bereich der Schaufel ohne Ausbildung von Kanten oder dergleichen ergibt. In gleicher Weise kann auch ein kontinuierlicher Übergang zwischen dickeren Bereichen der Erosionsschutzschicht zu weniger dicken Bereichen der Erosionsschutzschicht und umgekehrt erfolgen. Die Schichtdicke der Erosionsschutzschicht kann beispielsweise dahingehend variieren, dass an der Strömungseintrittskante und/oder der Strömungsaustrittskante der Schaufel eine zur Schaufelblattfläche unterschiedliche Schichtdicke der Erosionsschutzschicht abgeschieden wird. Beispielsweise kann die Erosionsschutzschicht an der Ein - und/oder Austrittskante der Schaufel mit einer Dicke zwischen 20 % und 200 % der Schichtdicke am Schaufelblatt abgeschieden werden.

### KURZBESCHREIBUNG DER FIGUREN

Die beigefügten Zeichnungen zeigen in rein schematischer Weise in
- Fig. 1: eine perspektivische Darstellung eines ersten Ausführungsbeispiels erfindungsgemäß hergestellter Schaufeln in Form einer beschaufelten Scheibe (Blisk),
- Fig. 2: eine perspektivische Ansicht eines zweiten Ausführungsbeispiels einer erfindungsgemäß hergestellten Schaufel, wie sie in Strömungsmaschinen eingesetzt werden kann,
- Fig. 3: eine Schnittansicht durch das Schaufelblatt der Schaufel gemäß Figur 2 und in
- Fig. 4: eine Schnittansicht durch den Schichtaufbau einer erfindungsgemäß abgeschiedenen Erosionsschutzschicht.

### AUSFÜHRUNGSBEISPIELE

Weitere Vorteile, Kennzeichen und Merkmale der vorliegenden Erfindung werden bei der nachfolgenden detaillierten Beschreibung von Ausführungsbeispielen deutlich. Allerdings ist die Erfindung nicht auf diese Ausführungsbeispiele beschränkt.

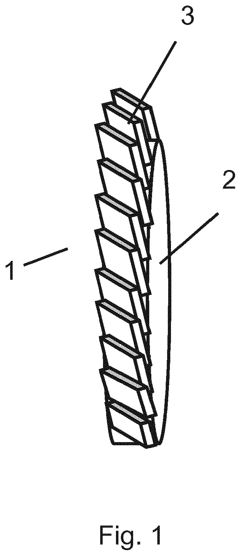

Die Fig. 1 zeigt eine perspektivische Darstellung einer sogenannten Blisk 1 (Blade Integrated Disk or Integrally Bladed Rotor), die eine Scheibe 2 und eine Vielzahl daran integral angeordneter Schaufeln 3 aufweist. Die gezeigte Blisk 1 ist eine einreihige Blisk 1, bei der nur eine umlaufende Reihe von Schaufeln 3 vorgesehen ist. Es können jedoch auch Blisktrommeln zum Einsatz kommen (nicht gezeigt), bei der mehrere Schaufelreihen nebeneinander an einer oder mehreren miteinander integral verbundenen Scheiben vorgesehen sind. Beispielsweise lassen sich derartige Blisktrommeln durch das axiale Verschweißen von mehreren Blisken 1, wie sie in Fig. 1 dargestellt sind, erzeugen. Auch derartige Blisktrommeln können durch das erfindungsgemäße Verfahren hergestellt werden.

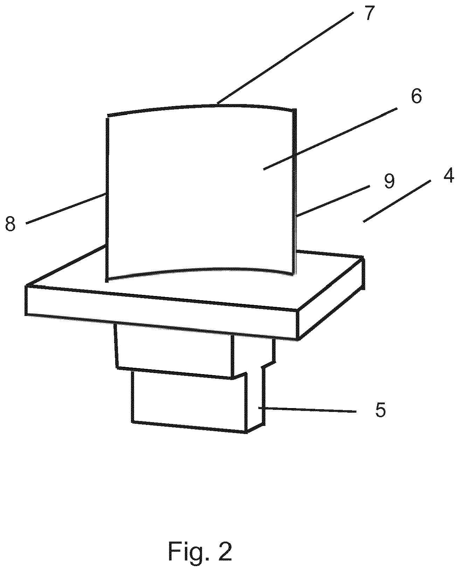

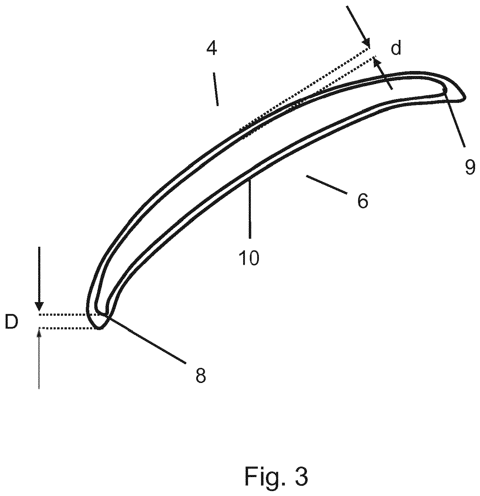

Die Figur 2 zeigt in einer rein schematischen Weise eine perspektivische Ansicht einer Schaufel, wie sie in einer Strömungsmaschine, wie beispielsweise einer stationären Gasturbine oder einem Flugtriebwerk eingesetzt werden kann. Die Schaufel 4 weist einen Schaufelfuß 5 auf, der in eine Scheibe eingesetzt werden kann, die mit einer Welle der Strömungsmaschine dreht. Die Schaufel 4 weist weiterhin ein Schaufelblatt 6 auf, welches im Strömungskanal der Strömungsmaschine angeordnet ist und entweder das Fluid, das durch die Strömungsmaschine fließt, verdichtet oder durch das vorbeiströmende Fluid angetrieben wird. An dem radial außenliegenden Ende der Schaufel 4 befindet sich die sogenannte Schaufelspitze 7, die zur Vermeidung von Strömungsverlusten möglichst eng an einem umgebenden Strömungskanalgehäuse anliegt oder sich in dieses sogar einschleift. Zu diesem Zweck wird an der Schaufelspitze 7 eine Schaufelspitzenpanzerung vorgesehen (siehe Fig. 3), die auch eine Schneidfunktion aufweist, sodass sich die Schaufelspitze 7 in ein umgebendes Strömungskanalgehäuse beziehungsweise daran angeordnetes Dichtungsmaterial einschneiden kann. Beispielsweise kann die Schaufelspitzenpanzerung durch eine Beschichtung mit einer Nickel - Matrix mit eingelagerten, kubischen Bornitrid - Partikeln gebildet sein.

Das Schaufelblatt 6 weist ebenfalls zum Schutz der Schaufel 4 eine Beschichtung auf, nämlich eine Erosionsschutzschicht 10, die das Material der Schaufel 4 vor Erosionsverschleiß schützen soll. Eine derartige Erosionsschutzschicht 10 kann aus einer sogenannten Multi - Layer - Schicht beziehungsweise Mehrlagen - Schicht bestehen, die aus einer Vielzahl von alternierend abgeschiedenen harten und weichen Schichten, insbesondere Keramikschichten und Metallschichten, bestehen kann. Die Erosionsschutzschicht 10 kann im Wesentlichen auf dem Schaufelblatt 6 sowie an der Eintrittskante 8 und der Austrittskante 9 der Schaufel, aber auch an der Schaufelspitze 7 z.B. über einer Schaufelspitzenpanzerung (nicht gezeigt) abgeschieden sein.

Der Fig. 3 ist zu entnehmen, dass die Erosionsschutzschicht mit unterschiedlicher Schichtdicke auf der Schaufel 4 bzw. dem Schaufelblatt 6 abgeschieden sein kann. So kann beispielsweise die Schichtdicke D der Erosionsschutzschicht 10 an der Strömungseintrittskante 8 bis zu 200 % der Schichtdicke d der Erosionsschutzschicht 10 an der Schaufelblattfläche aufweisen. Darüber hinaus ist der Fig. 3 zu entnehmen, dass die Schichtdicke der Erosionsschutzschicht 10 kontinuierlich verändert werden kann, so dass kein abrupter Übergang oder eine Kante zwischen der Erosionsschutzschicht 10 an der Schaufelblattfläche und der Erosionsschutzschicht 10 an der Eintrittskante 8 oder der Austrittskante 9 vorliegt. Bei der Ausführungsform der Fig. 3 ist die Erosionsschutzschicht 10 im Querschnitt um das gesamt Schaufelblatt 6 angeordnet, wobei jedoch die Erosionsschutzschicht 10 auch nur teilweise auf dem Schaufelblatt 6 aufgebracht sein kann, beispielsweise nur an der Druckseite und nicht an der Saugseite der Schaufel 4, wobei an den entsprechenden Grenzen, an denen die Erosionsschutzschicht 10 ausläuft, wieder ein entsprechend kontinuierlicher Übergang vorgesehen sein kann, sodass auf Abschlusskanten verzichtet wird, die zu ungünstigen Spannungsverhältnissen und zur Rissbildung führen könnten.

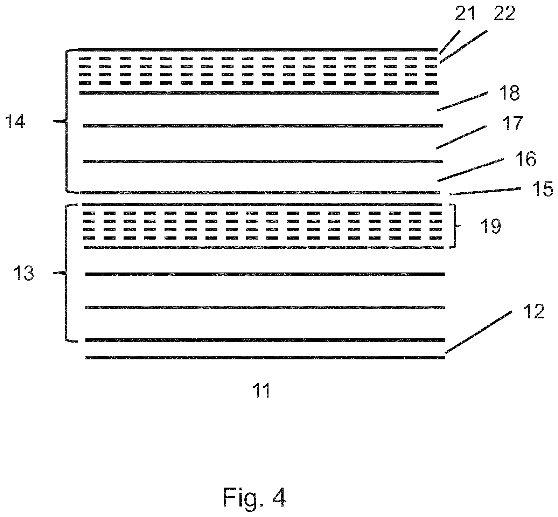

Die Figur 4 zeigt einen teilweisen Querschnitt durch eine erfindungsgemäße Erosionsschutzschicht, wie sie beispielsweise auf den Schaufeln 3 der Blisk 1 oder dem Schaufelblatt 6 der Schaufel 4 aufgebracht sein kann.

Bei dem gezeigten Ausführungsbeispiel der Fig. 4 ist auf dem Grundwerkstoff 11 der Schaufel 3 bzw. 4, der aus einer Titan - Legierung, einer Nickel - Legierung, Stahl, einem Verbundwerkstoff oder einem Keramik - Matrix - Verbundwerkstoff bzw. einem anderen geeigneten Grundwerkstoff gebildet sein kann, zunächst eine Haftvermittlerschicht 12 angeordnet, auf der die eigentliche Erosionsschutzschicht 10 angeordnet ist. Die Haftvermittlerschicht 12 kann aus einem keramischen Werkstoff, insbesondere einem Gradientenwerkstoff, der ausgehend von der Grenzfläche an dem Grundwerkstoff 11 einen immer geringer werdenden Anteil des Grundwerkstoffs aufweist, gebildet sein. Beispielsweise kann die Haftvermittlerschicht 12 aus gradiertem CrN gebildet sein, wobei die CrN - Schicht gleichzeitig auch als Diffusionssperrschicht dient.

Über der Haftvermittlerschicht bzw. der Diffusionssperrschicht 12 sind zwei identische Schichtabfolgen 13 und 14 mit den jeweiligen Schichten 16, 17, 18, 19 aufgebracht, die wiederum durch eine Diffusionssperrschicht 15, vorzugsweise aus CrN, voneinander getrennt sind.

Bei den einzelnen Schichten der Schichtabfolgen 13, 14 handelt es sich um eine Metallschicht 16, eine Metalllegierungsschicht 17, eine Metall - Keramik - Gradientenschicht 18 und eine nanostrukturierte Keramikschicht 19, die wiederum aus mehreren, alternierend vorgesehenen Keramikteilschichten 21,22 ausgebildet sind.

Die Metallschicht 16 ist bei dem gezeigten Ausführungsbeispiel beispielsweise als Chromschicht ausgebildet, während die Metalllegierungsschicht 17 eine Cr - Ni - Schicht ist. Bei der Metall - Keramik - Gradientenschicht 18 handelt es sich bei dem Ausführungsbeispiel um eine CrₓAl₁₋ₓN - Schicht, während die nanostrukturierte Keramikschicht 19 aus Keramikteilschichten 21,22 aus CrAlN und CrN gebildet sind.

Bei der nanostrukturierten Keramikschicht 19 können die Teilschichten 21,22 mit Schichtdicken im Bereich von 10 nm bis 200 nm ausgebildet sein, während die Schichtdicken der Schichten 16,17,18,19 der Schichtabfolgen 13,14 im Bereich von 0,2 µm bis 10 µm liegen können. Die einzelnen Schichten werden durch physikalische Dampfphasenabscheidung ( PVD physical vapour deposition) und insbesondere durch Kathodenzerstäubung (Sputtern) oder durch kathodische Lichtbogenabscheidung (CatArc) abgeschieden.

Nach dem Abscheiden der Schichten wird die oberste Schicht durch Schleifen und Polieren geglättet und die aufgebrachte Erosionsschutzschicht 10 kann vor oder nach dem Glätten der Oberfläche durch Kugelstrahlen verfestigt werden.

Obwohl die vorliegende Erfindung durch die Ausführungsbeispiele deutlich beschrieben worden ist, ist selbstverständlich, dass die Erfindung nicht auf diese Ausführungsbeispiele beschränkt ist, sondern dass vielmehr Abwandlungen in der Weise möglich sind, dass einzelne Merkmale weggelassen oder andersartige Kombinationen von Merkmalen verwirklicht werden können, so lange der Schutzbereich der beigefügten Ansprüche nicht verlassen wird. Die vorliegende Offenbarung schließt sämtliche Kombinationen der vorgestellten Einzelmerkmale mit ein.

### BEZUGSZEICHENLISTE

- 1: Blisk
- 2: Scheibe
- 3: Schaufel
- 4: Schaufel
- 5: Schaufelfuß
- 6: Schaufelblatt
- 7: Schaufelspitze
- 8: Eintrittskante
- 9: Austrittskante
- 10: Erosionsschutzschicht
- 11: Grundwerkstoff
- 12: Haftvermittlerschicht bzw. Diffusionssperrschicht
- 13: Schichtabfolge
- 14: Schichtabfolge
- 15: Diffusionssperrschicht
- 16: Metallschicht
- 17: Metalllegierungsschicht
- 18: Metall - Keramik - Gradientenschicht
- 19: nanostrukturierte Keramikschicht
- 21: Keramikteilschicht
- 22: Keramikteilschicht

## Patentansprüche

1. Verfahren zur Herstellung einer Schaufel oder Schaufelanordnung einer Strömungsmaschine, das die folgenden Schritte aufweist:
▪ Herstellen einer Schaufel (3,4) aus mindestens einem Schaufelwerkstoff,
▪ Bearbeitung der Schaufel in mindestens einem Bereich der Schaufel durch ein Oberflächenbearbeitungsverfahren, wobei das Oberflächenbearbeitungsverfahren mindestens ein Verfahren aus der Gruppe beinhaltet, die Schleifen, Gleitschleifen, Polieren, Elektropolieren, Verfestigungsstrahlen und Kugelstrahlen umfasst,
▪ Reinigung der Oberfläche der Schaufel,
▪ Abscheiden einer Erosionsschutzschicht (10) aus mindestens zwei unterschiedlich harten Schichten durch physikalische Dampfphasenabscheidung in dem mindestens einen Bereich,
▪ Bearbeitung der Erosionsschutzschicht (10) durch ein Schichtglättungsverfahren, um eine bestimmte Oberflächenrauheit einzustellen,
wobei nach der Bearbeitung der Schaufel durch ein Oberflächenbearbeitungsverfahren und vor dem Abscheiden der Erosionsschutzschicht die Abscheidung einer Spitzenpanzerung durchgeführt wird, wobei die Erosionsschutzschicht über der Schaufelspitzenpanzerung abgeschieden wird.

2. Verfahren nach Anspruch 1,
**dadurch gekennzeichnet, dass**
die Schaufel (3) als Teil einer Blisk (1) ausgebildet ist.

3. Verfahren nach einem der vorhergehenden Ansprüche,
**dadurch gekennzeichnet, dass**
der Schaufelwerkstoff ein Werkstoff aus der Gruppe ist, die Titan - Legierungen, Nickel
- Legierungen, Stahl, Verbundwerkstoffe und Keramik - Matrix - Verbundwerkstoffe umfasst.

4. Verfahren nach einem der vorhergehenden Ansprüche,
**dadurch gekennzeichnet, dass**
ein Mehrlagenschichtsystem mit einer oder mehreren sich wiederholenden Abfolgen (13,14) von mehreren Schichten (16,17,18,19) abgeschieden wird, wobei die Schichten aus einer Gruppe ausgewählt sind, die Metallschichten, Metalllegierungsschichten, Keramikschichten, Metall - Keramik - Schichten und gradierte Metall - Keramik - Schichten umfasst.

5. Verfahren nach Anspruch 4,
**dadurch gekennzeichnet, dass**
die Abfolge (13,14) von Schichten eine Dicke von weniger als 50 µm aufweist und/oder jede Schicht eine Dicke von 0,2 µm bis 10 µm aufweist.

6. Verfahren nach einem der Ansprüche 4 oder 5,
**dadurch gekennzeichnet, dass**
die Schichten (16,17,18,19) auf Chrombasis gebildet werden und Schichten aus Chrom, Chromlegierungen, CrAlN und CrN umfassen.

7. Verfahren nach einem der vorhergehenden Ansprüche,
**dadurch gekennzeichnet, dass**
eine Schicht (19), insbesondere die härteste von den Schichten oder einer sich wiederholenden Schichtabfolge, nanostrukturiert wird und in mehreren, insbesondere mehreren wechselseitig sich wiederholende Teilschichten (21,22) abgeschieden werden, von denen eine Teilschicht eine Dicke von 10 nm bis 200 nm aufweist.

8. Verfahren nach einem der vorhergehenden Ansprüche,
**dadurch gekennzeichnet, dass**
vor der Erosionsschutzschicht (10) eine Diffusionssperrschicht (12) und/oder eine Haftvermittlerschicht (12) abgeschieden wird.

9. Verfahren nach einem der vorhergehenden Ansprüche,
**dadurch gekennzeichnet, dass**
das Schichtglättungsverfahren mindestens ein Verfahren aus der Gruppe beinhaltet, die Schleifen, Gleitschleifen, Polieren und Elektropolieren umfasst.

10. Verfahren nach einem der vorhergehenden Ansprüche,
**dadurch gekennzeichnet, dass**
vor oder nach dem Schichtglättungsverfahren ein Verfestigungsstrahlen, insbesondere Kugelstrahlen durchgeführt wird.

11. Verfahren nach einem der vorhergehenden Ansprüche,
**dadurch gekennzeichnet, dass**
nach der Bearbeitung der Schaufel durch ein Oberflächenbearbeitungsverfahren und vor dem Abscheiden einer Erosionsschutzschicht ein Ablängen der Schaufel erfolgt.

12. Verfahren nach einem der vorhergehenden Ansprüche,
**dadurch gekennzeichnet, dass**
nach dem Schichtglättungsverfahren weitere Funktionsschichten aufgebracht werden.

13. Verfahren nach einem der vorhergehenden Ansprüche,
**dadurch gekennzeichnet, dass**
die Erosionsschutzschicht (10) bei teilweiser Aufbringung auf der Schaufel zu den Rändern der Erosionsschutzschicht mit abnehmender Schichtdicke abgeschieden wird und/oder an einer Strömungseintrittskante und/oder Strömungsaustrittskante der Schaufel mit zum Schaufelblatt unterschiedlicher Schichtdicke, insbesondere mit einer Dicke zwischen 20 % und 200 % der Schichtdicke am Schaufelblatt, vorzugsweise mit kontinuierlichem Übergang vom Schaufelblatt zur Strömungsein - oder - austrittskante abgeschieden wird.

14. Schaufel oder Schaufelanordnung einer Strömungsmaschine, insbesondere Blisk eines Flugtriebwerks, hergestellt mit einem Verfahren nach einem der vorhergehenden Ansprüche,
**dadurch gekennzeichnet, dass**
die durch das Schichtglättungsverfahren eingestellte bestimmte Oberflächenrauheit eine mittlere Rauheit Ra von gleich oder kleiner 0,5 µm ist.

## Claims

1. Method for producing a blade or blade arrangement of a turbomachine, comprising the following steps:
▪ producing a blade (3, 4) from at least one blade material,
▪ machining the blade in at least one region of the blade by means of a surface machining method, wherein the surface machining method includes at least one method from the group comprising grinding, vibratory grinding, polishing, electropolishing, peening and shot peening,
▪ cleaning the surface of the blade,
▪ depositing an erosion protection layer (10) from at least two layers of different hardness by means of physical vapor phase deposition in the at least one region,
▪ machining the erosion protection layer (10) by means of a layer smoothing method in order to set a certain surface roughness,
wherein, after machining the blade by means of a surface machining method and before depositing the erosion protection layer, tip armor is deposited, wherein the erosion protection layer is deposited over the blade tip armor.

2. Method according to claim 1,
**characterized in that**
the blade (3) is designed as part of a blisk (1).

3. Method according to either of the preceding claims,
**characterized in that**
the blade material is a material selected from the group comprising titanium alloys, nickel alloys, steel, composites, and ceramic matrix composites.

4. Method according to any of the preceding claims,
**characterized in that**
a multilayer system having one or more repeating sequences (13, 14) of a plurality of layers (16, 17, 18, 19) is deposited, the layers being selected from a group consisting of metal layers, metal alloy layers, ceramic layers, metal-ceramic layers and graded metal-ceramic layers.

5. Method according to claim 4,
**characterized in that**
the sequence (13, 14) of layers has a thickness of less than 50 µm and/or each layer has a thickness of from 0.2 µm to 10 µm.

6. Method according to either claim 4 or claim 5,
**characterized in that**
the layers (16, 17, 18, 19) are formed on a chromium base and comprise layers of chromium, chromium alloys, CrAIN and CrN.

7. Method according to any of the preceding claims,
**characterized in that**
a layer (19), in particular the hardest of the layers or a repeating layer sequence, is nano-structured and deposited in a plurality of, in particular a plurality of alternately repeating, sub-layers (21, 22), of which one sub-layer has a thickness of from 10 nm to 200 nm.

8. Method according to any of the preceding claims,
**characterized in that**
a diffusion barrier layer (12) and/or an adhesion promoter layer (12) is deposited before the erosion protection layer (10).

9. Method according to any of the preceding claims,
**characterized in that**
the layer smoothing method includes at least one method from the group comprising grinding, vibratory grinding, polishing and electropolishing.

10. Method according to any of the preceding claims,
**characterized in that**
peening, in particular shot peening, is carried out before or after the layersmoothing method.

11. Method according to any of the preceding claims,
**characterized in that**
after the blade has been machined by means of a surface machining method and before an erosion protection layer is deposited, the blade is cut to length.

12. Method according to any of the preceding claims,
**characterized in that**
further functional layers are applied after the layer smoothing method.

13. Method according to any of the preceding claims,
**characterized in that**
the erosion protection layer (10) is deposited, when partly applied to the blade, toward the edges of the erosion protection layerhaving decreasing layerthickness and/oron a flow inlet edge and/or flow outlet edge of the blade having a different layer thickness from the airfoil, in particular having a thickness of between 20% and 200% of the layer thickness on the airfoil, preferably having a continuous transition from the airfoil to the flow inlet or outlet edge.

14. Blade or blade arrangement of a turbomachine, in particular a blisk of an aircraft engine, produced using a method according to any of the preceding claims,
**characterized in that**
the specific surface roughness set by the layer smoothing method is an average roughness Ra of less than or equal to 0.5 µm.

## Revendications

1. Procédé destiné à la fabrication d'une aube ou d'un agencement d'aubes de turbomachine, présentant les étapes suivantes :
▪ fabrication d'une aube (3, 4) à partir d'au moins un matériau d'aube,
▪ traitement de l'aube dans au moins une zone de l'aube par un procédé de traitement de surface, le procédé de traitement de surface comprenant au moins un procédé dans le groupe constitué par le meulage, la tribofinition, le polissage, l'électropolissage, le grenaillage et le microbillage,
▪ nettoyage de la surface de l'aube,
▪ dépôt d'une couche de protection contre l'érosion (10) à partir d'au moins deux couches dures différentes par dépôt physique en phase vapeur dans l'au moins une zone,
▪ traitement de la couche de protection contre l'érosion (10) par un procédé de lissage de couche afin de fixer une rugosité de surface spécifique,
dans lequel après le traitement de l'aube par un procédé de traitement de surface et avant le dépôt de la couche de protection contre l'érosion, le dépôt d'un blindage de pointe est réalisé, la couche de protection contre l'érosion étant déposée sur le blindage de pointe d'aube.

2. Procédé selon la revendication 1,
**caractérisé en ce**
**que** l'aube (3) est conçue en tant que partie d'un disque aubagé monobloc (1).

3. Procédé selon l'une des revendications précédentes,
**caractérisé en ce**
**que** le matériau d'aube est un matériau choisi dans le groupe comprenant les alliages de titane, les alliages de nickel, l'acier, les matériaux composites et les matériaux composites à matrice céramique.

4. Procédé selon l'une des revendications précédentes,
**caractérisé en ce**
**qu'**un système multicouche comportant une ou plusieurs séquences répétitives (13, 14) de plusieurs couches (16, 17, 18, 19) est déposé, les couches étant choisies dans un groupe comprenant les couches métalliques, les couches d'alliage métallique, les couches céramiques, les couches céramo-métalliques et les couches céramo-métalliques graduées.

5. Procédé selon la revendication 4,
**caractérisé en ce**
**que** la séquence (13, 14) de couches présente une épaisseur inférieure à 50 µm et/ou chaque couche présente une épaisseur de 0,2 µm à 10 µm.

6. Procédé selon l'une des revendications 4 ou 5,
**caractérisé en ce**
**que** les couches (16,17,18,19) sont formées à base de chrome et comprennent des couches de chrome, d'alliages de chrome, de CrAIN et de CrN.

7. Procédé selon l'une des revendications précédentes,
**caractérisé en ce**
**qu'**une couche (19), en particulier la plus dure des couches ou une séquence de couches répétitives, est nanostructurée et est déposée en plusieurs, en particulier plusieurs sous-couches (21,22) répétitives alternativement, une sous-couche parmi les sous-couches présentant une épaisseurde 10 nm à 200 nm.

8. Procédé selon l'une des revendications précédentes,
**caractérisé en ce**
**qu'**une couche de barrière de diffusion (12) et/ou une couche adhésive (12) est déposée avant la couche de protection contre l'érosion (10).

9. Procédé selon l'une des revendications précédentes,
**caractérisé en ce**
**que** le procédé de lissage de couche contient au moins un procédé du groupe comprenant le meulage, la tribofinition, le polissage et l'électropolissage.

10. Procédé selon l'une des revendications précédentes,
**caractérisé en ce**
**qu'**un grenaillage, en particulier un microbillage, est réalisé avant ou après le procédé de lissage de couche.

11. Procédé selon l'une des revendications précédentes,
**caractérisé en ce**
**qu'**après le traitement de l'aube par un procédé de traitement de surface et avant le dépôt d'une couche de protection contre l'érosion, l'aube est coupée en longueur.

12. Procédé selon l'une des revendications précédentes,
**caractérisé en ce**
**que** d'autres couches fonctionnelles sont appliquées après le procédé de lissage de couche.

13. Procédé selon l'une des revendications précédentes,
**caractérisé en ce**
**que** la couche de protection contre l'érosion (10) est déposée par application partielle sur l'aube vers les bords de la couche de protection contre l'érosion avec une épaisseurde couche décroissante et/ou sur un rebord d'entrée d'écoulement et/ou un rebord de sortie d'écoulement de l'aube avec une épaisseurde couche différente de la pale, en particulier avec une épaisseur comprise entre 20 % et 200 % de l'épaisseur de couche sur la pale, déposée de préférence avec une transition continue de la pale au rebord d'entrée d'écoulement ou de sortie d'écoulement.

14. Aube ou agencement d'aubes de turbomachine, en particulierdisque aubagé monobloc de moteur d'aéronef, fabriqué avec un procédé selon l'une des revendications précédentes,
**caractérisé en ce**
**que** la rugosité de surface spécifique fixée par le procédé de lissage de couche est une rugosité moyenne Ra inférieure ou égale à 0,5 µm.
